# FASCICULE DE BREVET EUROPEEN

(11) **EP 1 732 122 B1**
(45) Date de publication et mention de la délivrance du brevet: **20.11.2013**
(21) Numéro de dépôt: 06354016.5
(22) Date de dépôt: 23.05.2006
(51) Int. Cl.: H01L 21/762

(54) **Procédé de réalisation d'un composant comportant au moins un élément à base de germanium**
Verfahren zur Herstellung eines Bauteils mit mindestens einer Germaniumschicht
Process of making a device having at least an element made of germanium

(30) Priorité: 06.06.2005 FR 0505701
(43) Date de publication de la demande: 13.12.2006
(73) Titulaire: Commissariat à l'Énergie Atomique et aux Énergies Alternatives, 75015 Paris (FR); STMICROELECTRONICS S.A., 92120 Montrouge (FR)
(72) Inventeur: Morand, Yves, 38000 Grenoble (FR); Poiroux, Thierry, 38340 Voreppe (FR); Vinet, Maud, 38140 Rives (FR)
(74) Mandataire: Hecké, Gérard

(56) Documents cités:
- WO-A-2004/001810
- FR-A- 2 852 144
- TEZUKA T ET AL: "HIGH-MOBILITY STRAINED SIGE-ON-INSULATOR PMOSFETS WITH GE-RICH SURFACE CHANNELS FABRICATED BY LOCAL CONDENSATION TECHNIQUE" IEEE ELECTRON DEVICE LETTERS, IEEE SERVICE CENTER, NEW YORK, NY, US, vol. 26, no. 4, avril 2005 (2005-04), pages 243-245, XP001230451 ISSN: 0741-3106
- NAKAHARAI S ET AL: "CHARACTERIZATION OF 7-NM-THICK STRAINED GE-ON-INSULATOR LAYER FABRICATED BY GE-CONDENSATION TECHNIQUE" APPLIED PHYSICS LETTERS, AIP, AMERICAN INSTITUTE OF PHYSICS, MELVILLE, NY, US, vol. 83, no. 17, 27 octobre 2003 (2003-10-27), pages 3516-3518, XP001192557 ISSN: 0003-6951

## Description

### Domaine technique de l'invention

L'invention concerne un procédé de réalisation d'un composant comportant au moins un élément à base de germanium, le procédé comportant la réalisation, sur un substrat, d'un empilement de couches comportant au moins une première couche en composé de germanium et silicium, la première couche étant disposée entre des secondes couches.

### État de la technique

Le germanium est un matériau intéressant pour la réalisation de composants microélectroniques comme, par exemple, les transistors à effet de champ, les transistors à un électron ou les mémoires, et également pour la réalisation de composants électromécaniques et de bio-composants, par exemple les puces à ADN. Le germanium pur présente une mobilité deux fois plus élevée pour les électrons et quatre fois plus élevée pour les trous que le silicium. L'inconvénient de transistors en germanium est le coût du substrat qui est environ dix fois plus élevé que celui d'un substrat de silicium massif. De plus, il est très difficile d'empiler plusieurs canaux en germanium par épitaxie de germanium de bonne qualité sur un substrat de silicium. Par ailleurs, la fabrication de ces transistors requiert de nombreux développements du fait de l'instabilité de l'oxyde de germanium.

On cherche à réaliser des canaux ou des îlots en germanium sur isolant, c'est-à-dire des éléments en germanium nanométriques en deux et en trois dimensions. Les îlots sont également connus sous le terme anglo-saxon « dots ». Ces éléments peuvent être disposés directement sur une couche isolante ou alors par l'intermédiaire d'un autre matériau, par exemple un matériau de grille dans le cas d'un transistor.

Une technique connue pour fabriquer des couches de germanium sur isolant est la technique de condensation de germanium, comme, par exemple, décrit dans l'article « Characterization of 7-nm-thick strained Ge-on-insulator layer fabricated by Ge-condensation technique » de S. Nakaharai et al. (Applied Physics letters volume 83 number 17; 27 October 2003). La technique consiste à oxyder un empilement de couches respectivement en silicium et en composé de silicium et germanium SiGe. Cet empilement de couches est lui-même disposé sur un diélectrique. Lors de l'oxydation, la teneur en germanium de la couche en SiGe augmente et peut dépasser 99%. Cette technique est appropriée à la fabrication de substrats de type germanium sur isolant. Cependant, cette technique présente l'inconvénient qu'il est difficile d'intercaler entre l'isolant et le germanium une couche d'un autre matériau, par exemple un matériau de grille.

L'article « High-Mobility Strained SiGe-on-Insulator pMOSFETs With Ge-Rich Surface Channels Fabricated by Local Condensation Technique » de T. Tezuka et al. (IEEE Electron Device Letters, Vol. 26, No. 4, avril 2005) décrit la fabrication d'un canal de transistor enrichi en germanium. Une zone de germanium condensé se forme directement sur l'isolant d'un substrat SOI, c'est-à-dire à l'emplacement initial de la couche de Si du SOI, par l'intermédiaire d'une oxydation effectuée par le haut.

### Objet de l'invention

L'invention a pour but de remédier à ces inconvénients et de proposer un procédé de réalisation d'îlots et de canaux en germanium, éventuellement superposés, tout en utilisant des procédés standard, notamment les procédés d'intégration de transistors sur silicium.

Selon l'invention, ce but est atteint par le procédé décrit dans la revendication 1.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 à 9 représentent trois étapes d'un premier mode de réalisation particulier du procédé selon invention, respectivement en vue de dessus (figures 1, 4 et 7), en coupe selon l'axe B-B (figures 2, 5 et 8) et en coupe selon l'axe AA (figures 3, 6 et 9).
Les figures 10 à 15 représentent deux étapes d'un second mode de réalisation particulier du procédé selon l'invention, respectivement en vue de dessus (figures 10 et 13), en coupe selon l'axe B-B (figures 11 et 14) et en coupe selon l'axe AA (figures 12 et 15).
Les figures 16 à 18 illustrent trois autres modes de réalisation particuliers du procédé selon l'invention.

### Description de modes particuliers de réalisation

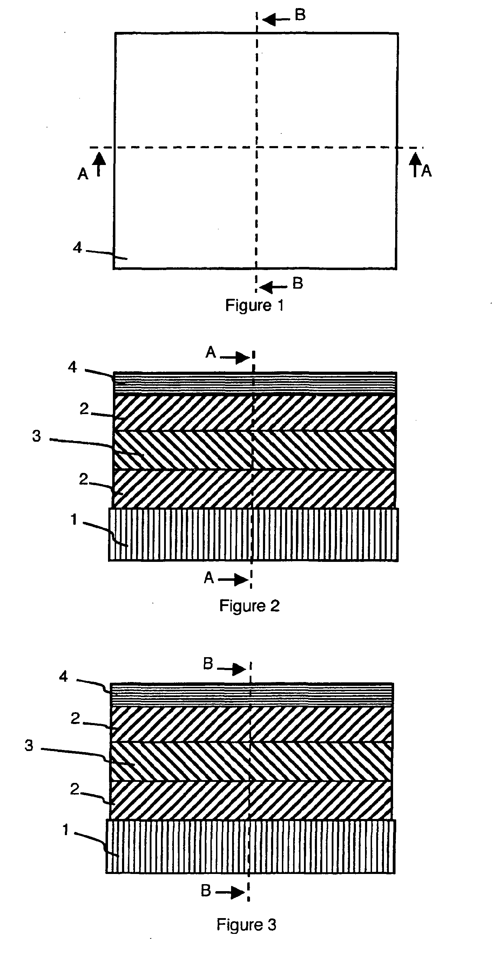

Les figures 1 à 3 représentent la réalisation, sur un substrat 1, par exemple en silicium Si, d'un empilement de première (3) et secondes (2) couches alternantes en composé de germanium et silicium GeSi. Les couches alternantes 3 et 2 ont respectivement des première et seconde concentrations de germanium. La première concentration de germanium est comprise entre 10% et 50% et est, de préférence, de 30% et la seconde concentration est comprise entre 0% et 10% et est, de préférence, de 0%. Sur les figures 2 et 3, une première couche 3 est disposée entre deux secondes couches 2. L'empilement peut être réalisé, par exemple, par hétéro-épitaxie de SiXGe(1-X)/SiYGe(1-Y) sur un substrat de silicium ou de type silicium sur isolant (« SOI : silicon on insulator »). L'épaisseur des couches 2 et 3 en SiGe est choisie, de manière connue, telle que l'épaisseur critique de relaxation plastique n'est pas dépassée pour les concentrations de germanium utilisées. Par exemple, l'épaisseur d'une couche est comprise entre 10nm et 100nm pour une couche de SiGe comportant 25% de germanium. Le nombre des premières couches 3 en SiGe détermine le nombre d'éléments à base de germanium formés par le procédé.

Le procédé comporte, de préférence, le dépôt d'une couche de passivation 4 sur une face avant de l'empilement de couches 2 et 3, avant de passer à une étape suivante de gravure de l'empilement. La couche de passivation 4 est, par exemple, une couche en nitrure de silicium (Si3N4), permettant de protéger la face avant de l'empilement contre l'oxydation ultérieure.

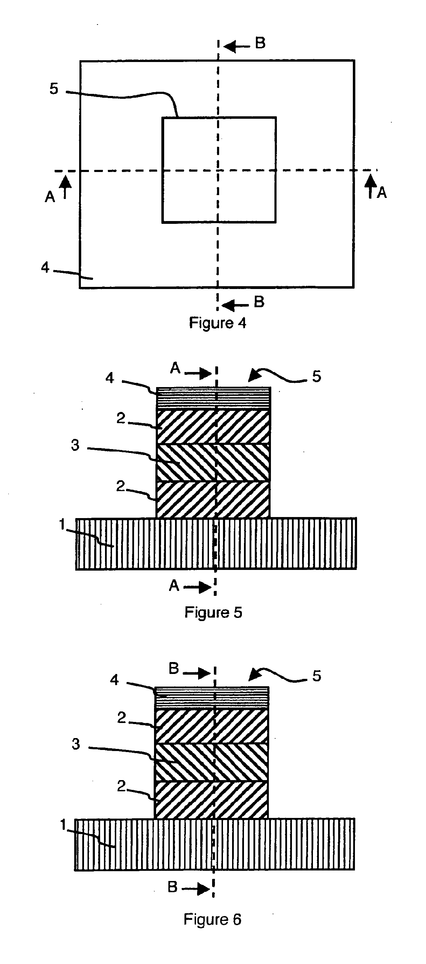

Les figures 4 à 6 illustrent la délimitation par gravure, dans ledit empilement, d'une première zone 5 ayant deux dimensions latérales comprise entre 10nm et 500nm, notamment une première dimension latérale suivant l'axe A-A et une seconde dimension latérale suivant l'axe B-B, sur la figure 4. La première zone 5 est délimitée par exemple, de manière connue, par dépôt d'une résine, photo-lithographie de la résine, gravure plasma anisotrope de l'empilement de couches et retrait de la résine.

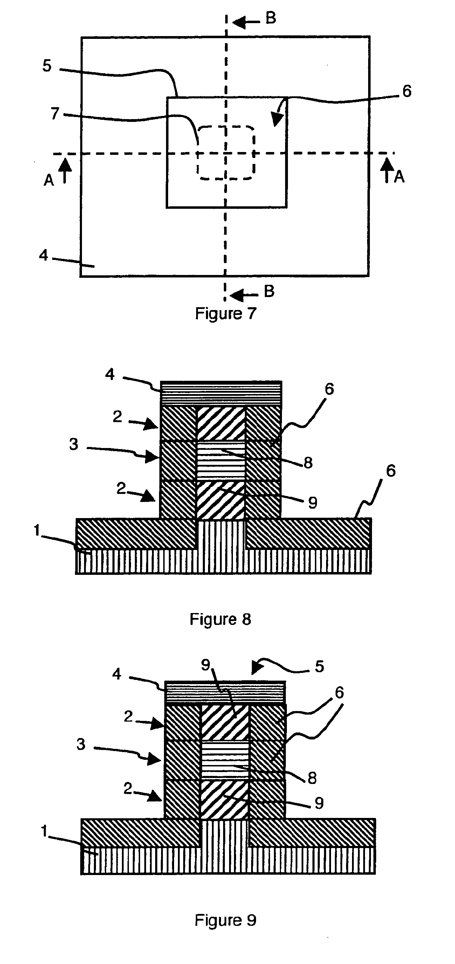

Les figures 7 à 9 illustrent une étape d'oxydation thermique superficielle, au moins latérale, de la première zone 5, de manière à ce qu'une couche de silice 6 (SiO2) se forme à la surface de la première zone 5. Lorsqu'une couche de passivation 4 est disposée sur la face avant de l'empilement de couches, la couche de silice 6 se forme sur les faces latérales de l'empilement et, éventuellement, sur la face avant du substrat 1, si le substrat 1 est, par exemple, en silicium Si. La couche de passivation 4 empêche ainsi, l'oxydation complète de la face avant de la seconde couche 2 supérieure de l'empilement de couches alternantes.

Dans ce mode de réalisation, comme représenté par la ligne pointillée 7 à la figure 7, la couche de silice 6 se forme superficiellement. L'oxygène pénètre dans l'empilement de couches jusqu'à une profondeur prédéterminée représentée par la ligne pointillée 7. L'intérieur de la première zone 5 n'est donc pas forcément oxydé lors de l'oxydation thermique. L'oxydation thermique superficielle est effectuée de manière à ce que, dans la première couche 3 ayant initialement la première concentration de germanium, une zone centrale 8 de germanium condensé se forme. La zone centrale 8 de germanium condensé constitue l'élément à base de germanium, par exemple sous forme d'un îlot. Lorsque seule la première dimension latérale de la première zone 5 est comprise entre 10nm et 500nm et une seconde dimension latérale est supérieure à 500nm, par exemple de 1000nm, la première zone 5 présente une forme allongée et la zone centrale 8 correspondante de germanium condensé constitue un élément à base de germanium allongé, par exemple sous forme d'un canal.

Dans les secondes couches 2 ayant initialement la seconde concentration de germanium, des zones centrales 9 résiduelles de SiGe présentent éventuellement une concentration de germanium différente de la concentration initiale. En effet, les zones centrales 9 des secondes couches 2 peuvent s'enrichir en germanium au détriment de la surface des secondes couches 2 qui est transformée en silice (la couche de silice 6). Ces phénomènes dépendent, de manière connue, des concentrations initiales de germanium et des paramètres utilisés pour l'étape d'oxydation, par exemple de la température, de la durée d'oxydation, etc... En particulier, les zones centrales 9 des secondes couches 2 peuvent être complètement oxydées.

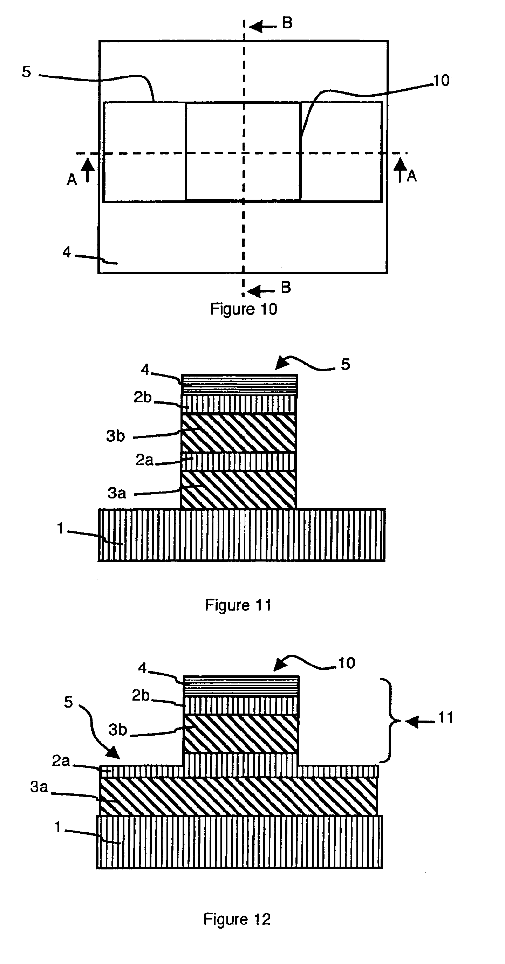

Dans un second mode de réalisation particulier, représenté aux figures 10 à 15, l'empilement de couches alternantes comporte deux premières couches 3a et 3b ayant la première concentration de germanium et deux secondes couches 2a et 2b ayant la seconde concentration de germanium. La première couche 3a inférieure est disposée sur le substrat 1. Les secondes couches 2a et 2b et le substrat 1 sont, de préférence, en silicium pur (Si). Ainsi, la première couche supérieure 3b de l'empilement est disposée entre les deux secondes couches 2a et 2b en silicium et la première couche 3a inférieure est disposée entre la seconde couche 2a inférieure en silicium et le substrat 1 en silicium.

Comme représenté aux figures 10 à 12, une première zone 5 allongée suivant l'axe A-A est délimitée dans l'empilement de couches alternantes. La première zone 5 allongée a une première, petite, dimension latérale comprise entre 10nm et 500nm et une seconde, grande, dimension latérale supérieure à 500nm, par exemple de 1000nm. Ensuite, une seconde zone 10 est délimitée par gravure dans une partie supérieure 11 de la première zone 5. La partie supérieure 11 de la première zone 5 comporte la première couche supérieure 3b des deux premières couches 3 ayant la première concentration de germanium et, ainsi, la couche supérieure 2b des deux secondes couches 2. La gravure correspondant à la seconde zone 10 est arrêtée à mi-chemin entre les deux premières couches 3a et 3b, au niveau de la seconde couche inférieure 2a, par exemple lorsque la moitié de celle-ci est gravée. Ainsi, la seconde zone 10 a deux, petites, dimensions latérales comprises entre 10nm et 500nm. La gravure de la seconde zone 10 peut, comme précédemment, être effectuée, par exemple, par dépôt d'une résine, photo-lithographie de la résine, gravure plasma anisotrope et retrait de la résine.

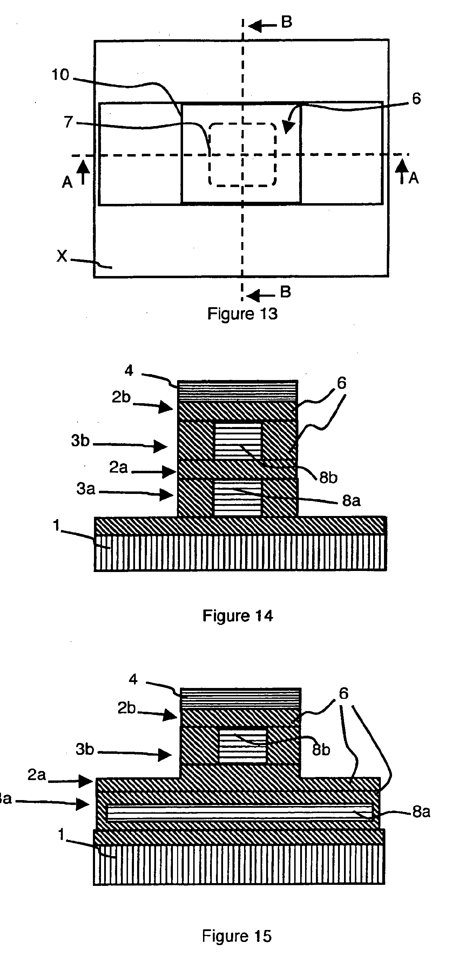

Les figures 13 à 15 illustrent l'oxydation thermique effectuée de manière à ce qu'une couche de silice 6 se forme à la surface des première (5) et seconde (10) zones et en ce que, dans les premières couches 3a et 3b ayant initialement la première concentration de germanium, des zones centrales 8a et 8b de germanium condensé se forment respectivement. Dans ce mode de réalisation particulier, le silicium des secondes couches 2a et 2b est complètement oxydé au cours de l'oxydation. Le substrat 1 est oxydé sur sa face avant. Les zones centrales 8a et 8b de germanium condensé des premières couches inférieure 3a et supérieure 3b constituent respectivement un canal en germanium et un îlot en germanium, correspondant respectivement à la première (5) et à la seconde (10) zone. On obtient alors un composant comportant deux éléments à base de germanium enrobés de silice.

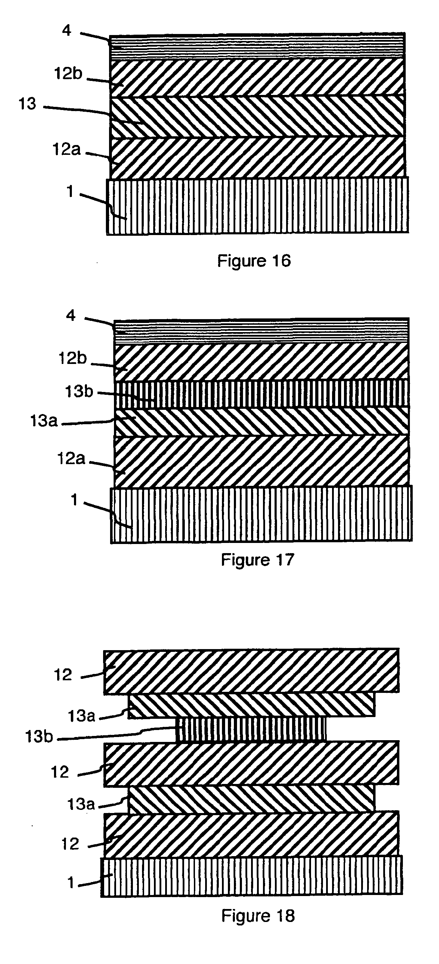

Selon l'invention, l'empilement de couches comporte au moins une première couche en composé de germanium et silicium ayant initialement une concentration de germanium comprise entre 10% et 50%. La première couche est disposée entre des secondes couches ayant des concentrations de germanium comprises entre 0% et 10%. Il ne s'agit donc pas nécessairement d'une alternance périodique de couches. Comme représenté à la figure 16, l'empilement comporte au moins une première couche 13 en SiGe ayant une concentration de germanium initiale comprise entre 10% et 50%. La première couche 13 est disposée entre des secondes couches 12a et 12b ayant des concentrations de germanium comprises entre 0% et 10%. La couche 12a et/ou la couche 12b peuvent, par exemple, être constituées par de la silice (SiO2), du silicium (Si), par du nitrure de silicium (Si3N4) ou par un composé de germanium et de silicium ayant une concentration de germanium comprise entre 0% et 10%.

Comme précédemment, l'oxydation thermique, au moins latérale, de la première zone 5 est effectuée de manière à ce que la zone centrale 8 de germanium condensé se forme dans la première couche 13. Les premières et/ou secondes couches sont, de préférence, dopées afin d'augmenter les cinétiques d'oxydation.

Par ailleurs, chacune des couches 12a, 12b et 13 peut être constituée par plusieurs sous-couches remplissant les conditions de concentrations de germanium ci-dessus. Sur la figure 17, par exemple, la première couche 13 est constituée par deux sous-couches 13a et 13b. Par exemple, lors que les deux sous-couches 13a et 13b ont des concentrations en germanium différentes, l'élément à base de germanium obtenu est une superposition de deux parties ayant des dimensions verticales et des concentrations en germanium différentes. Par ailleurs, une première couche 13 peut être directement disposée sur le substrat 1, lorsque celui-ci présente une concentration en germanium inférieure à 10%. Ainsi, le substrat 1 constitue une des secondes couches.

Comme représenté à la figure 18, les dimensions latérales des premières et secondes couches peuvent être adaptées, avant condensation, par exemple par une gravure isotrope sélective dépendant de la concentration de germanium. Sur la figure 18, les secondes couches 12 sont en SiGe_{z} et ont une concentration de germanium comprise entre 0 et 10%. Les premières couches 13 sont en SiGeₓ (13a) et SiGe_{y} (13b) et ont des concentrations de germanium comprise entre 10 et 50%, celle de SiGe_{y} (13b) étant supérieure à celle de SiGeₓ (13a).

L'invention n'est pas limitée aux modes de réalisation particuliers représentés. En particulier, le nombre de canaux et/ou d'îlots peut être supérieur à deux. Par exemple plusieurs canaux en germanium peuvent être réalisés par l'intermédiaire d'un empilement comportant plusieurs premières couches. Plusieurs îlots en germanium peuvent être disposés de manière alignée au-dessus d'un canal unique en germanium. Les dimensions finales des éléments en germanium dépendent des dimensions initiales des premières (5) et secondes (10) zones, des épaisseurs des premières couches et des concentrations initiales en germanium des premières couches. Il est possible de superposer des canaux de dimensions différentes.

## Revendications

1. Procédé de réalisation d'un composant comportant au moins un élément à base de germanium sur un substrat, procédé **caractérisé en ce que** le substrat comporte un empilement de couches (2, 3 ; 12a, 12b, 13) comportant une première couche (3, 13) en composé de germanium et silicium disposée entre des secondes couches (12a, 12b, 2), le procédé comporte:
- la délimitation par gravure, dans ledit empilement d'une première zone (5) correspondant à l'élément à base de germanium (3, 13) et comportant des faces latérales et une face avant, la première zone ayant au moins une première dimension latérale comprise entre 10nm et 500nm,
- l'oxydation thermique des faces latérales de la première zone (5), de manière à former une couche de silice (8) et une zone centrale (8) de germanium condensé dans la première couche (3), la zone centrale (8) de germanium condensé constituant l'élément à base de germanium
la première couche (3, 13) en composé de germanium et silicium ayant initialement une concentration de germanium comprise entre 10% et 50%, les secondes couches (12a, 12b, 2) ayant des concentrations de germanium comprises entre 0% et 10%.

2. Procédé selon la revendication 1, **caractérisé en ce qu'**il comporte, avant la délimitation par gravure, le dépôt d'une couche de passivation (4) sur l'empilement de couches (2, 3; 12a, 12b, 13).

3. Procédé selon l'une des revendications 1 et 2, **caractérisé en ce que** les premières (3,13) et/ou secondes couches (2, 12a, 12b) sont dopées.

4. Procédé selon l'une quelconque des revendications 1 à 3, **caractérisé en ce que** l'empilement de couches est constitué par une alternance de premières (3) et secondes (2) couches en composé de germanium et silicium ayant respectivement des première et seconde concentrations de germanium.

5. Procédé selon la revendicadon 4, **caractérisé en ce que** la première concentration de germanium est de 30% et la seconde concentration est de 0%.

6. Procédé selon l'une des revendications 4 et 5, **caractérisé en ce que** l'empilement de couches alternantes (2, 3) comporte une première couche (3) et deux secondes couches (2).

7. Procédé selon l'une des revendications 4 et 5, **caractérisé en ce que** l'empilement de couches alternantes (2, 3) comporte deux premières couches (3) et deux secondes couches (2), l'une des deux premières couches (3) étant disposée directement sur le substrat (1).

8. Procédé selon la revendication 7, **caractérisé en ce qu'**une seconde dimension latérale de la première zone (5) est supérieure à 500nm et le procédé comporte la délimitation par gravure, dans une partie supérieure (11) de la première zone (5) comportant la couche supérieure (3b) des deux premières couches (3), d'une seconde zone (10) ayant deux dimensions latérales comprises entre 10nm et 500nm.

9. Procédé selon la revendication 8, **caractérisé en ce que** la gravure pour la délimitation de la seconde zone (10) est arrêtée à mi-chemin entre les deux premières couches (3a, 3b).

## Patentansprüche

1. Verfahren zur Herstellung eines Bauteils mit mindestens einem Germaniumelement auf einem Substrat, **dadurch gekennzeichnet, dass** das Substrat einen Stapel von Schichten (2, 3; 12a, 12b, 13) mit einer ersten Schicht (3, 13) aus einer Verbindung von Germanium und Silizium umfasst, die zwischen zweiten Schichten (12a, 12b, 2) angeordnet ist, wobei das Verfahren Folgendes umfasst:
- die Abgrenzung durch Ätzung in dem Stapel von einem ersten Bereich (5), der dem Gemianiumelement (3, 13) entspricht und Seitenflächen sowie eine vordere Fläche umfasst, wobei der erste Bereich mindestens eine erste seitliche Abmessung zwischen 10nm und 500nm aufweist,
- die Wärmeoxidation der Seitenflächen des ersten Bereiches (5) derart, dass eine Kieselsäureschicht (6) und ein mittiger Bereich (8) aus verdichtetem Germanium in der ersten Schicht (3) gebildet wird, wobei der mittige Bereich (8) aus verdichtetem Germanium das Germaniumelement bildet,
wobei die erste Schicht (3, 13) aus einer Verbindung von Germanium und Silizium zunächst eine Germaniumkonzentration zwischen 10% und 50% aufweist, wobei die zweiten Schichten (12a, 12b, 2) Germaniumkonzentrationen zwischen 0% und 10% aufweisen.

2. Verfahren gemäß Anspruch 1, **dadurch gekennzeichnet, dass** es vor der Abgrenzung durch Ätzung die Aufbringung einer Passivierungsschicht (4) auf dem Stapel von Schichten (2, 3; 12a, 12b, 13) umfasst.

3. Verfahren gemäß einem der Ansprüche 1 und 2, **dadurch gekennzeichnet, dass** die ersten (3, 13) und/oder zweiten Schichten (2, 12a, 12b) dotiert sind.

4. Verfahren gemäß einem der Ansprüche 1 bis 3, **dadurch gekennzeichnet, dass** der Stapel von Schichten aus einem Wechsel von ersten (3) und zweiten (2) Schichten aus einer Verbindung von Germanium und Silizium besteht, die jeweils erste und zweite Germaniumkonzentrationen aufweisen.

5. Verfahren gemäß Anspruch 4, **dadurch gekennzeichnet, dass** die erste Germaniumkonzentration 30% beträgt und die zweite Konzentration 0% beträgt.

6. Verfahren gemäß einem der Ansprüche 4 und 5, **dadurch gekennzeichnet, dass** der Stapel der wechselnden Schichten (2, 3) eine erste Schicht (3) und zwei zweite Schichten (2) umfasst.

7. Verfahren gemäß einem der Ansprüche 4 und 5, **dadurch gekennzeichnet, dass** der Stapel der wechselnden Schichten (2, 3) zwei erste Schichten (3) und zwei zweite Schichten (2) umfasst, wobei die eine der beiden ersten Schichten (3) unmittelbar auf dem Substrat (1) angebracht ist.

8. Verfahren gemäß Anspruch 7, **dadurch gekennzeichnet, dass** eine zweite seitliche Abmessung des ersten Bereiches (5) über 500nm liegt und das Verfahren die Abgrenzung durch Ätzung in einem oberen Teil (11) des ersten Bereiches (5) umfasst, der die obere Schicht (3b) der beiden ersten Schichten (3) aufweist, wobei ein zweiter Bereich (10) zwei seitliche Abmessungen zwischen 10nm und 500nm aufweist.

9. Verfahren gemäß Anspruch 8, **dadurch gekennzeichnet, dass** die Ätzung für die Abgrenzung des zweiten Bereiches (10) auf halbem Wege zwischen den beiden ersten Schichten (3a, 3b) gestoppt wird.

## Claims

1. Method for producing a component comprising at least one germanium-based element on a substrate, method **characterized in that** the substrate comprises a stack of layers (2, 3, 12a, 12b, 13) comprising a first layer (3, 13) made of germanium and silicon compound, the first layer being arranged between second layers (12a, 12b, 2), the method comprises :
- delineation by etching, in said stack, of a first zone corresponding to the germanium-based element (3, 13) and comprising lateral faces and a front face, the first zone having at least a first lateral dimension comprised between 10nm and 500nm,
- thermal oxidization of the lateral faces of the first zone, so as to form a silica layer (6) and a central zone (8) made of condensed germanium in the first layer (3), the central zone made of condensed germanium forming the germanium-based element,
the first layer (3, 13) made of germanium and silicon compound initially having a germanium concentration comprised between 10% and 50%, the second layers (12a, 12b, 2) having germanium concentrations comprised between 0% and 10%.

2. Method according to claim 1, **characterized in that** it comprises deposition of a passivation layer (4) on the stack of layers (2, 3, 12a, 12b, 13), before delineation by etching.

3. Method according to one of the claims 1 and 2, **characterized in that** the first (3, 13) and/or second layers (2, 12a, 12b) are doped.

4. Method according to anyone of the claims 1 to 3, **characterized in that** the stack of layers is formed by an alternation of first (3) and second (2) layers of germanium and silicon compound respectively having first and second germanium concentrations.

5. Method according to claim 4, **characterized in that** the first germanium concentration is 30% and the second concentration is 0%.

6. Method according to one of the claims 4 and 5, **characterized in that** the stack of alternate layers (2, 3) comprises a first layer (3) and two second layers (2).

7. Method according to one of the claims 4 and 5, **characterized in that** the stack of alternate layers (2, 3) comprises two first layers (3) and two second layers (2), one of the two first layers (3) being arranged directly on the substrate (1).

8. Method according to claim 7, **characterized in that** a second lateral dimension of the first zone (5) is greater than 500nm and the method comprises delineation by etching, in a top part (11) of the first zone (5) comprising the top layer (3b) of the two first layers (3), of a second zone (10) having two lateral dimensions comprised between 10nm and 500nm.

9. Method according to claim 8, **characterized in that** the etching for delineation of the second zone (10) is stopped half-way between the two first layers (3a, 3b).
